# EUROPEAN PATENT APPLICATION

(11) **EP 4 542 437 A1**
(43) Date of publication of application: **23.04.2025**
(21) Application number: 23925591.2
(22) Date of filing: 13.11.2023
(51) Int. Cl.: G06F 30/392

(54) **DEVICE LAYOUT METHOD AND APPARATUS FOR CHIP LAYOUT, AND COMPUTER DEVICE AND STORAGE MEDIUM**

(30) Priority: 08.09.2023 CN 202311160034
(71) Applicant: TENCENT TECHNOLOGY (SHENZHEN) COMPANY LIMITED, Shenzhen, Guangdong 518057 (CN)
(72) Inventor: XU, Xiong, Shenzhen, Guangdong 518057 (CN); YE, Kai, Shenzhen, Guangdong 518057 (CN); HUAI, Sainan, Shenzhen, Guangdong 518057 (CN); ZHANG, Shengyu, Shenzhen, Guangdong 518057 (CN); ZHENG, Yicong, Shenzhen, Guangdong 518057 (CN)
(74) Representative: Gunzelmann, Rainer
(86) International application number: PCT/CN2023/131163
(87) International publication number: WO 2025/050506

(57) **Abstract**

Embodiments of this application disclose a method and an apparatus for component arrangement on a chip layout, a computer device, and a storage medium, and relate to the field of chip technologies. The method includes: obtaining a chip layout on which a first component and a second component are to be arranged (301); determining, based on a first arrangement parameter of the first component, a genus region for the first component on the chip layout, the first arrangement parameter being used for arrangement of the first component on the chip layout, and the genus region being a hollow region located in the first component on the chip layout (302); and arranging the second component in a region other than the genus region on the chip layout based on a second arrangement parameter of the second component and the genus region when the genus region does not support arrangement of the second component, the second arrangement parameter being used for the arrangement of the second component on the chip layout (303).

## Description

### RELATED APPLICATION

This application claims priority to Chinese Patent Application No. 202311160034.2, entitled "METHOD AND APPARATUS FOR COMPONENT ARRANGEMENT ON CHIP LAYOUT, COMPUTER DEVICE, AND STORAGE MEDIUM" and filed on September 8, 2023, which is incorporated herein by reference in its entirety.

### TECHNICAL FIELD

Embodiments of this application relate to the field of chip technologies, and in particular, to a method and an apparatus for component arrangement on a chip layout, a computer device, and a storage medium.

### BACKGROUND

To implement functions of performing calculation and information processing, core components (such as superconducting qubits and reading cavities) and auxiliary components (such as indium columns, magnetic flux capture holes, and through holes in a multi-layer stacked chip) of different types are arranged on a chip.

In the related art, electronic design automation (EDA) tools are generally used for arrangement of the core components and the auxiliary components on a layout. When the core components are already on the layout, the auxiliary components are usually laid evenly on the entire layout in a specific array, a Boolean difference operation is performed on the auxiliary components and the core components, and a result of the operation is used as an arrangement scheme for the auxiliary components.

### SUMMARY

Embodiments of this application provide a method and an apparatus for component arrangement on a chip layout, a computer device, and a storage medium. Technical solutions are as follows:

According to an aspect, an embodiment of this application provides a method for component arrangement on a chip layout. The method is executable by a computer device, and the method includes:
obtaining a chip layout comprising a first region for arranging a first chipset component and a second region for arranging second chipset component;
determining, based on a first arrangement parameter of the first chipset component, a genus region for the first chipset component on the chip layout, the genus region being a hollow region located in the first region of the chip layout; and
when the genus region does not support arrangement of the second chipset component, arranging the second chipset component in the second region of the chip layout based on a second arrangement parameter of the second chipset component and the genus region, the second region being different from the first region.

According to another aspect, an embodiment of this application provides an apparatus for component arrangement on a chip layout. The apparatus includes:
an obtaining module, configured to obtain a chip layout comprising a first region for arranging a first chipset component and a second region for arranging second chipset component;
a determining module, configured to determine, based on a first arrangement parameter of the first chipset component, a genus region for the first chipset component on the chip layout, the genus region being a hollow region located in the first region of the chip layout; and
an arrangement module, configured to arrange the second chipset component in the second region of the chip layout based on a second arrangement parameter of the second chipset component and the genus region when the genus region does not support arrangement of the second chipset component, the second region being different from the first region.

According to another aspect, an embodiment of this application provides a computer device. The computer device includes a processor and a memory. The memory has at least one computer instruction stored therein. The at least one computer instruction is configured for being executed by the processor, to implement the method for component arrangement on a chip layout according to the above aspect.

According to another aspect, an embodiment of this application provides a computer-readable storage medium. The computer-readable storage medium has at least one computer instruction stored therein. The computer instruction is configured for being loaded and executed by a processor, to implement the method for component arrangement on a chip layout according to the above aspect.

According to another aspect, an embodiment of this application provides a computer program product. The computer program product includes computer instructions. The computer instructions are stored in a computer-readable storage medium. A processor of a terminal reads the computer instructions from the computer-readable storage medium, and the processor executes the computer instructions, to enable the terminal to perform the method for component arrangement on a chip layout according to the above aspect.

In the embodiments of this application, based on the first arrangement parameter of the first chipset component arranged in the first region of the chip layout, the genus region for the first chipset component on the chip layout can be determined. Because the genus region is the hollow region within the first region of the chip layout, when the genus region does not support the arrangement of the second chipset component, based on the second arrangement parameter of the second chipset component and the genus region, the second chipset component is arranged in a region other than the genus region on the chip layout, which can avoid that the second chipset component is arranged in the hollow region for the first chipset component, and reduce problems of abnormal operation of the chipset component, thereby improving component arrangement quality of the chip layout.

### BRIEF DESCRIPTION OF THE DRAWINGS

FIG. 1 is a schematic diagram of a genus region existing in a core component according to an exemplary embodiment of this application.
FIG. 2 is a schematic diagram in which an auxiliary component is arranged in a genus region in a core component according to an exemplary embodiment of this application.
FIG. 3 is a flowchart of a method for component arrangement on a chip layout according to an exemplary embodiment of this application.
FIG. 4 is a schematic diagram of an arrangement node sequence according to an exemplary embodiment of this application.
FIG. 5 is a schematic diagram of an arrangement node sequence according to another exemplary embodiment of this application.
FIG. 6 is a schematic diagram in which a second chipset component is arranged in a region other than an intersection between candidate arrangement regions and a genus region in the candidate arrangement regions according to an exemplary embodiment of this application.
FIG. 7 is a schematic diagram in which a target control is configured based on a protobuf protocol according to an exemplary embodiment of this application.
FIG. 8 is a flowchart of arrangement of a second chipset component on a chip layout according to an exemplary embodiment of this application.
FIG. 9 is a schematic diagram in which candidate arrangement adjustment regions are translated according to an exemplary embodiment of this application.
FIG. 10 is a schematic diagram in which a second chipset component is added to a genus region when an area of the genus region is greater than an area threshold according to an exemplary embodiment of this application.
FIG. 11 is a schematic diagram in which a second chipset component is added to a genus region when density of the second chipset component in a subblock is less than a density threshold according to an exemplary embodiment of this application.
FIG. 12 is a structural block diagram of an apparatus for component arrangement on a chip layout according to an exemplary embodiment of this application.
FIG. 13 is a schematic structural diagram of a computer device according to an exemplary embodiment of this application.

### DETAILED DESCRIPTION

To make objectives, technical solutions, and advantages of this application clearer, implementations of this application are described below in further detail with reference to the accompanying drawings.

To arrange auxiliary components on a chip layout, in the related art, EDA tools are used for evenly laying the auxiliary components on the chip layout in an array, a Boolean difference operation is performed on the auxiliary components and core components that are already arranged on the chip layout, and a result of the operation is used as an arrangement scheme of the auxiliary components.

However, due to various structures and functions of components, when the components are arranged directly by using the Boolean difference operation, it is prone to cause abnormal operation of the components.

In a possible scenario, a genus region may exist in the core component on the chip layout. The genus region is a hollow region located in the core component on the chip layout.

"Genus" is a definition in topology. For a graph, if there are n non-intersecting closed curves in the graph, and the n non-intersecting closed curves do not divide the graph into different regions, the genus of the graph is n.

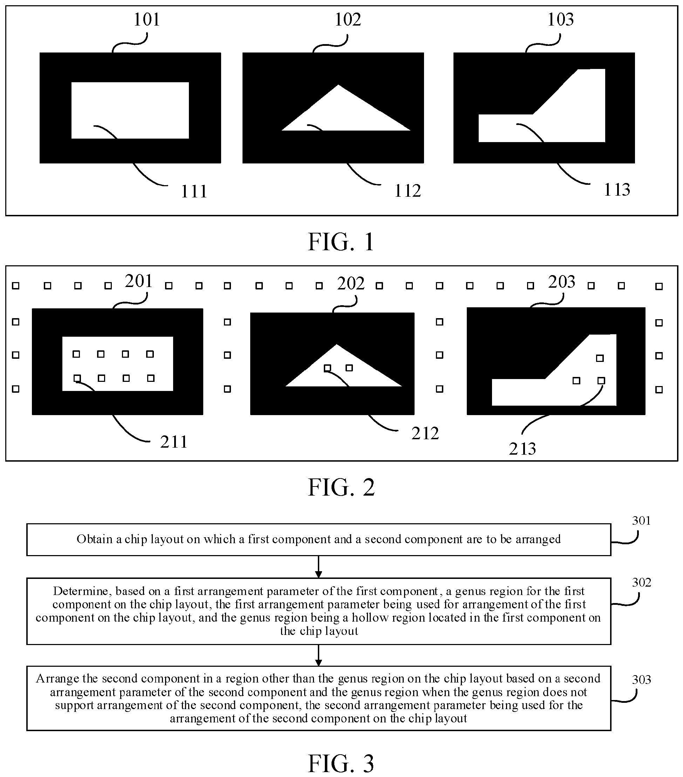

FIG. 1 is a schematic diagram of a genus region existing in a core component according to an exemplary embodiment of this application.

As shown in FIG. 1, a rectangular genus region 111 exists in a core component 101, a triangular genus region 112 exists in a core component 102, and an irregularly polygonal genus region 113 exists in a core component 103.

In this embodiment, an example in which the genus region is a rectangle, a triangle, or an irregular polygon is used for description, but is not limited thereto. The genus region in the core component may be actually in various shapes, for example, a genus region of a "cross" structure may exist in a superconducting qubit, or a genus region of another special structure (such as a "flipmon" structure) may exist. Such genus regions of various shapes are all within the protection scope of this application.

When a genus region exists in a core component, auxiliary components are laid evenly on a chip layout in an array, and a Boolean difference operation is performed on the auxiliary components and the core component that is already arranged on the chip layout, so that the auxiliary components may be arranged in the genus region in the core component, and when the genus region does not support arrangement of the auxiliary components, the core component may operate abnormally.

FIG. 2 is a schematic diagram in which an auxiliary component is arranged in a genus region in a core component according to an exemplary embodiment of this application.

As shown in FIG. 2, when a genus region exists in a core component, auxiliary components are laid evenly on a chip layout in an array, and a Boolean difference operation is performed on the auxiliary components and the core component that is already arranged on the chip layout, so that eight auxiliary components (including auxiliary components 211) are arranged in a genus region in a core component 201, two auxiliary components (including auxiliary components 212) are arranged in a genus region in a core component 202, and three auxiliary components (including auxiliary components 213) are arranged in a genus region in a core component 203. When the above genus regions do not support the arrangement of the auxiliary components, the core component 201, the core component 202, and the core component 203 may operate abnormally.

To resolve the problem of abnormal operation caused by the auxiliary component being arranged in the genus region in the core component, this application provides a method for component arrangement on a chip layout, so that the auxiliary component may not be arranged in the genus region in the core component, thereby improving component arrangement quality of the chip layout is improved, and resolving the problem of abnormal operation.

FIG. 3 is a flowchart of a method for component arrangement on a chip layout according to an exemplary embodiment of this application. The method is performed by a computer device. In some embodiments, the computer device includes an application program (for example, EDA tools) having a chip layout generation function. The flowchart includes the following operations:
Operation 301. Obtain a chip layout on which a first component (also called a first chipset component) and a second component (also called a second chipset component) are to be arranged. Specifically, the chip layout includes a first region for arranging the first chipset component and a second region for arranging the second chipset component.

The chip layout is a layout reflecting related physical information such as component types and component sizes corresponding to various types of components, relative positions between components, and connection relationships between components in a chip.

In some embodiments, the chip layout is a layout corresponding to a superconducting quantum chip.

In some embodiments, the first component is a core component arranged on the chip layout, and the second component is an auxiliary component arranged on the chip layout.

In some embodiments, the first component is the core component such as a superconducting qubit, a resonant cavity, a reading cavity, or a top sheet test junction.

In some embodiments, the second component is the auxiliary component such as an indium column, a magnetic flux capture hole, or a through hole in a multi-layer stacked chip.

In some embodiments, the first component may alternatively be a core component of another type, and the second component may alternatively be an auxiliary component of another type. Specific types of the first component and the second component are not limited in the embodiments of this application.

The second component, as the auxiliary component, is configured to support the first component that is used as the core component. For example, on the superconducting quantum chip, the indium column is a protruding point made of indium, and is configured to establish an electrical connection between a bottom sheet and a top sheet, the magnetic flux capture hole is a micron-level small hole or perforation etched in a quantum processor, and is configured to capture magnetic flux and prevent the magnetic flux from interfering with a qubit, to reduce errors and impact on decoherence and improve accuracy of quantum computation, and the through hole in the multi-layer stacked chip is configured to run through a three-dimensional chip stacked in a vertical direction, to implement a vertical interconnection between chips and a vertical interconnection inside the chip.

Operation 302. Determine, based on a first arrangement parameter of the first component, a genus region for the first component on the chip layout, the first arrangement parameter being used for arrangement of the first component on the chip layout, and the genus region being a hollow region located in the first component on the chip layout. Herein, the genus region is a hollow region located within the first region of the chip layout.

The first arrangement parameter is configured for indicating how to arrange the first component on the chip layout.

In some embodiments, the first arrangement parameter includes parameters of a shape, a side length, a position, and a size of the first component, or a distance parameter between the first component and each of an upper margin, a lower margin, a left margin, and a right margin of the chip layout, or other parameters configured for the arrangement of the first component.

In some embodiments, the first arrangement parameter includes an arrangement node sequence. The arrangement node sequence includes a plurality of arrangement nodes, and the plurality of arrangement nodes are configured for representing a plurality of vertexes of the first component on the chip layout.

In some embodiments, the arrangement node sequence includes a plurality of sequentially connected arrangement nodes. The plurality of arrangement nodes may be connected sequentially to form a communication region in which the first component is located.

The genus region corresponding to the first component is the hollow region located in the first component on the chip layout. For example, the genus region corresponding to the core component 101 in FIG. 1 is a rectangular region in the core component 101.

In some embodiments, it may be determined, based on the first arrangement parameter of the first component, whether a corresponding genus region exists in the first component. When the corresponding genus region exists in the first component, the genus region may be determined by using the first arrangement parameter configured for the arrangement of the first component.

Operation 303. Arrange the second component in a region other than the genus region on the chip layout based on a second arrangement parameter of the second component and the genus region when the genus region does not support arrangement of the second component, the second arrangement parameter being used for arrangement of the second component on the chip layout. Herein, the region other than the genus region is the second region, and the second region is different from the first region.

In some embodiments, all or some of genus regions on the chip layout may not support the arrangement of the second component.

The second arrangement parameter is configured for indicating how to arrange the second component on the chip layout.

In some embodiments, the second arrangement parameter includes parameters of a shape, a side length, a position, and a size of the second component, or a distance parameter between the second component and the upper margin, the lower margin, the left margin, and the right margin of the chip layout, or other parameters configured for the arrangement of the second component.

In some embodiments, the second arrangement parameter further includes a distance limiting parameter between the second component and the first component. The distance limiting parameter is configured for ensuring a spacing between the first component and the second component, to avoid abnormal operation caused by excessive proximity between the components.

In a possible implementation, the computer device may arrange, according to the second arrangement parameter, the second component in a region that does not have an intersection with the genus region on the chip layout.

In some embodiments, the computer device may obtain the first arrangement parameter and the second arrangement parameter set by a user, to perform component arrangement on the chip layout according to the first arrangement parameter and the second arrangement parameter.

To determine the genus region corresponding to the first component according to the first arrangement parameter, in some embodiments, the computer device may set the first arrangement parameter according to a specific rule.

In some embodiments, the first arrangement parameter includes an arrangement node sequence. The arrangement node sequence includes sequentially connected arrangement nodes. A communication region formed by sequentially connecting the arrangement nodes is an arrangement region of the first component.

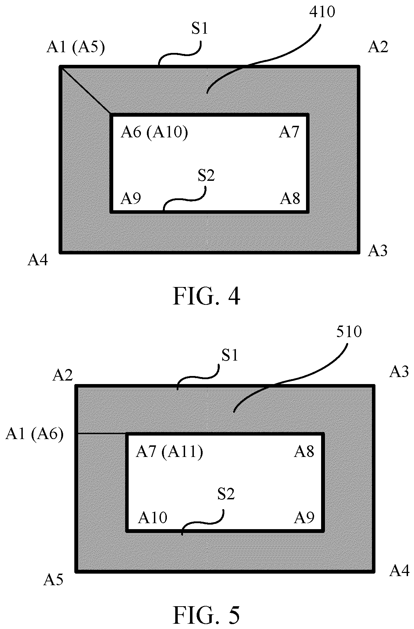

FIG. 4 is a schematic diagram of an arrangement node sequence according to an exemplary embodiment of this application.

As shown in FIG. 4, the first arrangement parameter corresponding to the first component may include an arrangement node sequence <A1, A2, A3, A4, A5, A6, A7, A8, A9, A10>.

A communication region 410 formed by sequentially connecting arrangement nodes A1, A2, A3, A4, A5, A6, A7, A8, A9, and A10 is an arrangement region of the first component.

In some embodiments, a first communication node and a second communication node in the arrangement node sequence may be determined. The first communication node and the second communication node are adjacent nodes in the arrangement node sequence, and a connection line between the first communication node and the second communication node is located within the communication region.

For example, two adjacent nodes A5 and A6 exist in the arrangement node sequence <A1, A2, A3, A4, A5, A6, A7, A8, A9, A10>, and a connection line A5A6 formed by A5 and A6 is located within the communication region, so that A5 may be used as the first communication node, and A6 may be used as the second communication node; or A5 is used as the second communication node, and A6 is used as the first communication node.

In some embodiments, an arrangement node having same node coordinates with a head arrangement node in the arrangement node sequence may be alternatively determined as the first communication node, and an adjacent node of the first communication node is determined as the second communication node.

For example, in the arrangement node sequence <A1, A2, A3, A4, A5, A6, A7, A8, A9, A10>, A5 has same node coordinates with a head arrangement node A1 in the arrangement node sequence. Therefore, A5 may be used as the first communication node, and an adjacent node A6 of the first communication node A5 is determined as the second communication node.

To determine the genus region corresponding to the first component according to the first arrangement parameter, in some embodiments, the arrangement nodes in the arrangement node sequence are sequentially traversed in a first direction by using the first communication node as a start, to obtain a first closed curve formed by connecting the arrangement nodes.

For example, the arrangement nodes in the arrangement node sequence <A1, A2, A3, A4, A5, A6, A7, A8, A9, A10> are sequentially traversed in a reverse order direction by using the first communication node A5 as a start, to obtain a first closed curve S1 formed by connecting the arrangement nodes A5, A4, A3, A2, and A1.

The arrangement nodes in the arrangement node sequence are sequentially traversed in a second direction by using the second communication node as a start, to obtain a second closed curve formed by connecting the arrangement nodes. The first direction is opposite to the second direction.

For example, the arrangement nodes in the arrangement node sequence <A1, A2, A3, A4, A5, A6, A7, A8, A9, A10> are sequentially traversed in a sequential direction by using the second communication node A6 as a start, to obtain a second closed curve S2 formed by connecting the arrangement nodes A6, A7, A8, A9, and A10.

In some embodiments, the genus region may be determined based on the first closed curve and the second closed curve.

In some embodiments, an enclosed region corresponding to the second closed curve is determined as the genus region when the enclosed region corresponding to the second closed curve is located within an enclosed region corresponding to the first closed curve.

As shown in FIG. 4, an enclosed region corresponding to the second closed curve S2 is located within an enclosed region corresponding to the first closed curve S1. Therefore, the enclosed region corresponding to the second closed curve S2 may be determined as the genus region.

In some embodiments, node coordinates of arrangement vertexes on the first closed curve S1 and the second closed curve S2 may be compared, to determine whether the enclosed region corresponding to the second closed curve S2 is located within the enclosed region corresponding to the first closed curve S1.

In some embodiments, the first communication node or the second communication node may be located on a vertex or a boundary of the arrangement region of the first component. For example, in FIG. 4, the first communication node A5 and the second communication node A6 are located on vertexes of the arrangement region 410 of the first component. In FIG. 5, a first communication node A6 is located on a boundary of an arrangement region 510 of the first component, and a second communication node A7 is located on a vertex of the arrangement region 510 of the first component.

FIG. 5 is a schematic diagram of an arrangement node sequence according to another exemplary embodiment of this application.

As shown in FIG. 5, the first arrangement parameter corresponding to the first component may include an arrangement node sequence <A1, A2, A3, A4, A5, A6, A7, A8, A9, A10, A11>.

A communication region 510 formed by sequentially connecting arrangement nodes A1, A2, A3, A4, A5, A6, A7, A8, A9, A10, and A11 is an arrangement region of the first component.

Two adjacent nodes A6 and A7 exist in the arrangement node sequence <A1, A2, A3, A4, A5, A6, A7, A8, A9, A10, A11>, and a connection line A6A7 formed by A6 and A7 is located within the communication region. Therefore, A6 may be used as the first communication node, and A7 may be used as the second communication node; or A6 is used as the second communication node, and A7 is used as the first communication node.

Alternatively, because node coordinates of A6 are the same as node coordinates of a head arrangement node A1 in the arrangement node sequence, A6 may be used as the first communication node, and an adjacent node A7 of the first communication node A6 is determined as the second communication node.

The arrangement nodes in the arrangement node sequence <A1, A2, A3, A4, A5, A6, A7, A8, A9, A10, A11> are sequentially traversed in a reverse order direction by using the first communication node A6 as a start, to obtain a first closed curve S1 formed by connecting the arrangement nodes A6, A5, A4, A3, A2, and A1.

The arrangement nodes in the arrangement node sequence <A1, A2, A3, A4, A5, A6, A7, A8, A9, A10, A11> are sequentially traversed in a sequential direction by using the second communication node A7 as a start, to obtain a second closed curve S2 formed by connecting the arrangement nodes A7, A8, A9, A10, and A11.

In some embodiments, an enclosed region corresponding to the second closed curve S2 is located within an enclosed region corresponding to the first closed curve S1. Therefore, the enclosed region corresponding to the second closed curve S2 may be determined as the genus region.

In this embodiment, after the first communication node and the second communication node are determined based on the arrangement node sequence, traverse may be performed in a reverse direction, to determine the first closed curve and the second closed curve, so that the genus region is efficiently determined, thereby improving efficiency of component arrangement.

When the second component is arranged on the chip layout, it may be determined, based on the second arrangement parameter of the second component and the genus region, whether an intersection exists between a region of the second component and the genus region. When the intersection exists, the second component is not arranged in the region.

In some embodiments, candidate arrangement regions of the second component on the chip layout may be determined based on the second arrangement parameter.

In some embodiments, the candidate arrangement regions may be determined in a uniform array according to the parameters of the shape, the side length, the position, and the size of the second component and the distance parameter between the second component and each of the upper margin, the lower margin, the left margin, and the right margin of the chip layout in the second arrangement parameter.

In some embodiments, the candidate arrangement regions may alternatively be determined based on the distance limiting parameter between the first component and the second component, to ensure that a distance between the candidate arrangement region and the arrangement region of the first component is greater than or equal to the distance limiting parameter.

In some embodiments, the candidate arrangement regions may be determined in a uniform array in a region other than the arrangement region of the first component on the chip layout.

When the genus region does not support the arrangement of the second component, and an intersection exists between the candidate arrangement regions and the genus region, the second component is arranged in a region other than the intersection in the candidate arrangement regions.

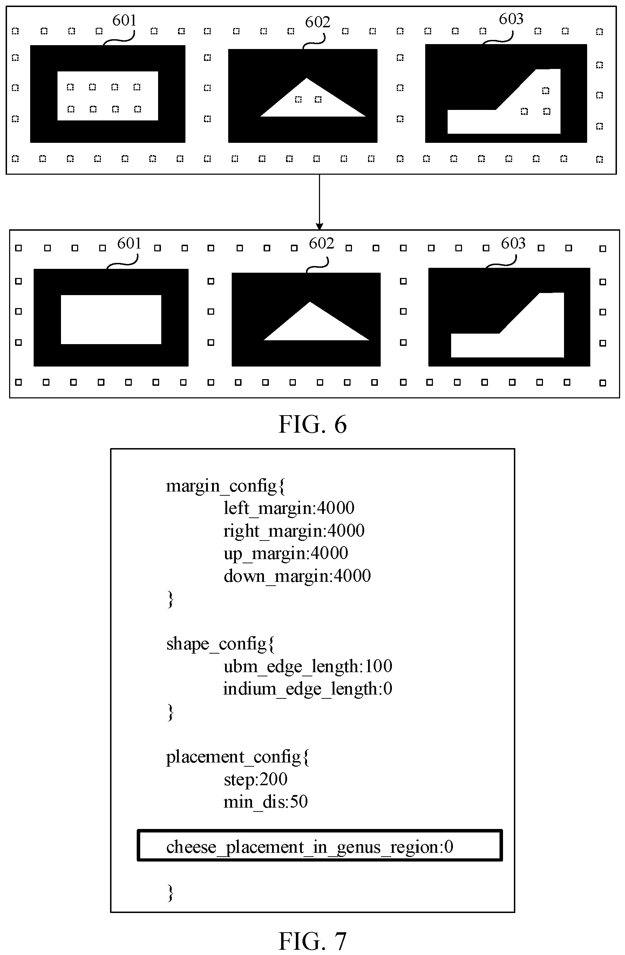

FIG. 6 is a schematic diagram in which a second component is arranged in a region other than an intersection between candidate arrangement regions and a genus region in the candidate arrangement regions according to an exemplary embodiment of this application.

As shown in FIG. 6, on a chip layout, a genus region corresponding to a first component 601 is a rectangular region, a genus region corresponding to a first component 602 is a triangular region, and a genus region corresponding to a first component 603 is an irregularly polygonal region.

In some embodiments, candidate arrangement regions (shown by dashed boxes) of a second component may be determined based on a second arrangement parameter. For example, in FIG. 6, the candidate arrangement regions of the second component exist both outside arrangement regions of the first components and in the genus regions corresponding to the first components.

In some embodiments, when none of the genus region corresponding to the first component 601, the genus region corresponding to the first component 602, and the genus region corresponding to the first component 603 supports arrangement of the second component, an intersection (which is a region in which the dashed box is located in the genus region) between the candidate arrangement regions of the second component and the genus region may be determined.

Therefore, the computer device arranges the second component in a region other than the intersection in the candidate arrangement regions, to form arrangement regions (shown by solid line boxes) of the second component, so that the second component is not arranged in the genus region corresponding to the first component, thereby avoiding abnormal operation. Herein, the region other than the intersection is a region other than the first region on the chip layout.

In a possible scenario, the genus region corresponding to the first component may support the arrangement of the second component.

For example, for some special component structures, for example, a "flipmon" structure of a superconducting qubit, a genus region supports arrangement of an indium column.

For example, for some special component functions, for example, a pad of a top sheet test junction, because after a top sheet and a bottom sheet are pressed and welded, node resistance of the bottom sheet after the pressing and welding needs to be measured, an indium column needs to be arranged in the pad of the top sheet test junction for connection; or when a control line from the bottom sheet to the top sheet needs to be added, an indium column also needs to be arranged in the pad of the top sheet test junction.

Therefore, in some embodiments, when the genus region supports the arrangement of the second component, and the intersection exists between the candidate arrangement regions and the genus region, or when the intersection does exist between the candidate arrangement regions and the genus region, the computer device may arrange the second component in the candidate arrangement regions.

For determining an arrangement support situation of the genus region corresponding to the first component for the second component, at least one of the following manners may be included. The arrangement support situation includes that the genus region does not support the arrangement of the second component, or that the genus region supports the arrangement of the second component.
(1) In some embodiments, the arrangement support situation of the genus region corresponding to the first component for the second component may be determined based on component information of the first component.

The component information includes at least one of a component type, a component structure, or a component function.

In some embodiments, the component information further includes a component size or other information related to the first component, which is not limited in the embodiments.

In some embodiments, the component type of the first component is a type to which the first component belongs, for example, the component type may be a superconducting qubit, a reading cavity, or another type.

In some embodiments, the component structure of the first component is a morphology structure of the first component, for example, the component structure may be a "cross" structure, a "flipmon" structure, or the like.

In some embodiments, the component function of the first component is a function of the first component to be implemented, for example, the component function may be measuring node resistance after pressing and welding, or may be adding a control line from a bottom sheet to a top sheet.

(2) In some embodiments, the arrangement support situation of the genus region corresponding to the first component for the second component may be determined based on an on/off state of a target control. The target control has a genus arrangement control function.

In some embodiments, the target control may be configured to one-button control the arrangement support situations of the genus regions corresponding to all the first components on the chip layout for the second component, or may be configured to control the arrangement support situations of the genus regions corresponding to some first components for the second component.

In some embodiments, the computer device may configure the target control based on a protobuf protocol.

FIG. 7 is a schematic diagram in which a target control is configured based on a protobuf protocol according to an exemplary embodiment of this application.

As shown in FIG. 7, in a protobuf protocol-based configuration file, the target control may be configured by setting a parameter value of "cheese_placement_in genus_region".

For example, "cheese_placement_in_genus_region:0" indicates that none of the genus regions corresponding to all the first components on the chip layout supports the arrangement of the second component.

For example, "cheese_placement_in_genus_region:1" indicates that the genus regions corresponding to all the first components on the chip layout support the arrangement of the second component.

The arrangement support situation of the genus region for the second component can be determined according to use requirements through the parameter value of the "cheese_placement_in_genus_region".

In the protobuf protocol-based configuration file, the first arrangement parameter or the second arrangement parameter may be further set. For example, the distance parameter between the second component and each of the upper margin, the lower margin, the left margin, and the right margin of the chip layout may be set based on parameters in "margin_config" (for example, all parameter values of "left_margin", "right_margin", "up_margin", and "down_margin" being 4000 indicates that the distance between the second component and each of the upper margin, the lower margin, the left margin, and the right margin of the chip layout cannot be less than 4000 microns). Size parameters of second component in a bottom sheet and a top sheet may be set based on "shape_config" (for example, "ubm_edge_length:100" indicates that a side length of an indium column in the top sheet is 100 microns, and "indium_edge_length:0" indicates that no indium column is arranged in the bottom sheet). A spacing between the second components and the distance limiting parameter between the second component and the first component may be set based on "placement_config" (for example, "step:200" indicates that a spacing between indium columns is 200 microns, and a distance between the indium column and the first component does not exceed 50 microns).

In FIG. 7, only the target control is configured to control whether all the genus regions support or none of the genus regions supports the arrangement of the second component on the chip layout. Actually, individual controls may be alternatively set respectively for a plurality of first components of different component types, component structures, or component functions, to separately control a genus region corresponding to a single first component to support or not support the arrangement of the second component.

(3) A component combination of the first component and the second component is matched with a standard component combination, to determine the arrangement support situation of the genus region corresponding to the first component for the second component.

For example, the standard component combination is a preset component combination that supports the arrangement of the second component in the genus region of the first component, and when the matching succeeds, the arrangement support situation is determined as supporting the arrangement; or when the matching fails, the arrangement support situation is determined as not supporting the arrangement.

In some embodiments, the matching with the standard component combination may be performed based on features such as component types, component positions, or component sizes of the first component and the second component.

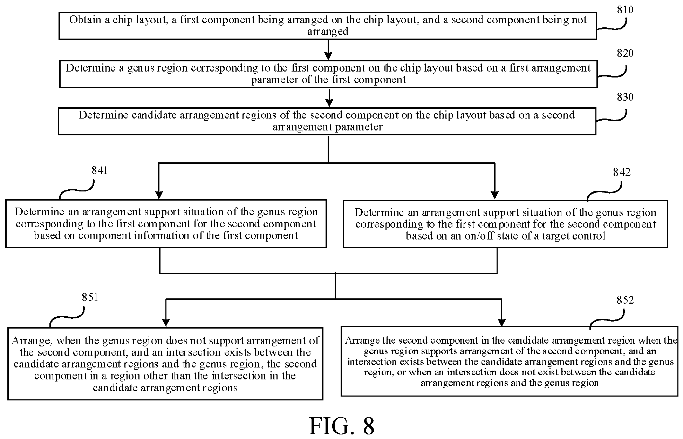

FIG. 8 is a flowchart of arrangement of a second component on a chip layout according to an exemplary embodiment of this application. The flowchart includes the following operations:
Operation 810. Obtain a chip layout, a first component and a second component being to be arranged on the chip layout.
Operation 820. Determine, based on a first arrangement parameter of the first component, a genus region corresponding to the first component on the chip layout.
Operation 830. Determine candidate arrangement regions of the second component on the chip layout based on a second arrangement parameter.

In some embodiments, the second arrangement parameter includes a size parameter of the second component, a spacing parameter between second components, and a distance limiting parameter between the second component and the first component.

In some embodiments, the candidate arrangement regions of the second component may be determined based on the second arrangement parameter according to a uniform array on the chip layout.

Operation 841. Determine, based on component information of the first component, an arrangement support situation of the genus region corresponding to the first component for the second component.

The component information includes at least one of a component type, a component structure, or a component function.

For example, when a combination of the component type and the component structure of the first component is a specific combination, the arrangement support situation of the genus region corresponding to the first component for the second component can be determined. For example, when the component type is a superconducting qubit, and the component structure is a "cross" structure, it is determined that the arrangement support situation is that the genus region does not support arrangement of the second component.

For example, when a combination of the component type and the component function of the first component is a specific combination, the arrangement support situation of the genus region corresponding to the first component for the second component can be determined. For example, when the component type is a pad of a top sheet test junction, and the component function is measuring node resistance of a bottom sheet after pressing and welding, it is determined that the arrangement support situation is that the genus region supports the arrangement of the second component.

In some embodiments, the component type may be obtained based on a type to which the first component belongs and that is stored in the computer device. In some embodiments, the component function may be obtained based on a user input.

In some embodiments, the component structure of the first component may be determined based on the first arrangement parameter. In some embodiments, the first arrangement parameter of the first component and a reference arrangement parameter of a reference component may be matched. When the matching succeeds, a component structure corresponding to the reference component is used as the component structure of the first component.

The reference component is a component having the component structure stored therein. For example, the reference component may be a standard component stored in the computer device, or another first component whose component structure is known.

Operation 842. Determine, based on an on/off state of a target control, the arrangement support situation of the genus region corresponding to the first component for the second component.

In some embodiments, a parameter value of a parameter "cheese_placement_in_genus_region" corresponding to the on/off state of the target control may be obtained from the protobuf protocol-based configuration file, to determine the arrangement support situation of the genus region corresponding to the first component for the second component. For example, the parameter value being 0 indicates that none of the genus regions corresponding to all the first components on the chip layout supports arrangement of the second component, and the parameter value being 1 indicates that the genus regions corresponding to all the first components on the chip layout support the arrangement of the second component.

After the arrangement support situation of the genus region corresponding to the first component for the second component is determined, the second component may be arranged on the chip layout based on the arrangement support situation.

Operation 851. Arrange, when the genus region does not support arrangement of the second component, and an intersection exists between the candidate arrangement regions and the genus region, the second component in a region other than the intersection in the candidate arrangement regions.

Operation 852. Arrange the second component in the candidate arrangement region when the genus region supports arrangement of the second component, and an intersection exists between the candidate arrangement regions and the genus region, or when an intersection does not exist between the candidate arrangement regions and the genus region.

In this embodiment, the arrangement support situation of the genus region for the second component may be determined by using at least one of the component type, the component structure, or the component function of the first component, or by using the on/off state of the target control, so that the second component may be arranged or may not be arranged in the genus region selectively, thereby enriching a component arrangement function of the chip layout and improving component arrangement quality.

After the second component is arranged on the chip layout, a layout of the second components may be adjusted in some regions (for example, a quantity of second components is increased, and the arrangement region of the second component is adjusted, to increase density of the second component), to improve the component arrangement quality.

In some embodiments, candidate arrangement adjustment regions of the second component may be determined. The candidate arrangement adjustment regions are candidate arrangement regions for layout adjustment of the second component. The density of the second component after the layout adjustment is higher than density of the second component before the layout adjustment.

In a process of layout adjustment, specific requirements and restrictions need to be met. In some embodiments, the second arrangement parameter includes the distance limiting parameter between the second component and the first component. After the layout adjustment, the distance between the second component and the first component needs to be still greater than or equal to the distance limiting parameter.

In a possible scenario, an intersection situation between the candidate arrangement regions and the genus region needs to be considered, and a manner of performing layout adjustment on the second component is determined based on the intersection situation.

The second component is arranged in the candidate arrangement adjustment region when the intersection does not exist between the candidate arrangement adjustment regions and the genus region, and a distance between the candidate arrangement adjustment region and the arrangement region of the first component is greater than or equal to the distance limiting parameter.

The layout of the second component is not adjusted when the intersection exists between the candidate arrangement adjustment regions and the genus region, or the distance between the candidate arrangement adjustment region and the arrangement region of the first component is less than the distance limiting parameter.

In a possible scenario, when the intersection exists between the candidate arrangement adjustment regions and the genus region, or the distance between the candidate arrangement adjustment region and the arrangement region of the first component is less than the distance limiting parameter, the candidate arrangement adjustment regions may be further translated according to a specific step. When an intersection does not exist between the translated candidate arrangement adjustment regions and the genus region, and a distance between the translated candidate arrangement adjustment region and the arrangement region of the first component is greater than or equal to the distance limiting parameter, the second component may be arranged in the translated candidate arrangement adjustment region.

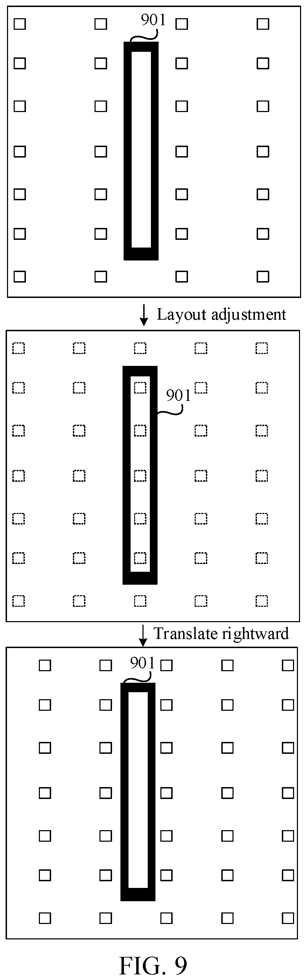

FIG. 9 is a schematic diagram in which candidate arrangement adjustment regions are translated according to an exemplary embodiment of this application.

As shown in FIG. 9, a genus region exists in a first component 901 on the chip layout. After the second component is arranged in the arrangement region (shown by a solid line box) of the second component on the chip layout, the layout of the second components may be adjusted, to improve the density of the second component.

To improve the density of the second component, the candidate arrangement adjustment regions (shown by dashed boxes) of the second component may be determined.

Because an intersection exists between the candidate arrangement adjustment regions and the genus region of the first component 901, the candidate arrangement adjustment regions may be translated according to a specific step.

In some embodiments, when the intersection exists between the candidate arrangement adjustment regions and the genus region, or the distance between the candidate arrangement adjustment region and the arrangement region of the first component is less than a distance limiting parameter, an adjustment step set can be determined.

The adjustment step set includes at least one candidate adjustment step. For example, the adjustment step set may be {10 microns, 9 microns, ..., 1 micron}.

In some embodiments, the candidate arrangement adjustment regions may be translated based on the i^{th} candidate adjustment step in the adjustment step set.

For example, the first candidate adjustment step of 10 microns in the adjustment step set is selected, and the candidate arrangement adjustment regions are translated leftward or rightward by 10 microns.

When the intersection does not exist between the translated candidate arrangement adjustment regions and the genus region, and the distance between the translated candidate arrangement adjustment region and the arrangement region of the first component is greater than or equal to the distance limiting parameter, the second component may be arranged in the translated candidate arrangement adjustment region.

When the intersection exists between the translated candidate arrangement adjustment regions and the genus region, or the distance between the translated candidate arrangement adjustment region and the arrangement region of the first component is less than the distance limiting parameter, the candidate arrangement adjustment regions are re-translated based on the (i+1)^{th} candidate adjustment step in the adjustment step set, until the second component can be arranged in the translated candidate arrangement adjustment region, or all candidate adjustment steps in the adjustment step set have been traversed.

For example, in FIG. 9, after the candidate arrangement adjustment regions of the second component are translated rightward based on the candidate adjustment step of 4 microns, the intersection does not exist between the candidate arrangement adjustment regions of the second component and the genus region of the first component, and the distance between the candidate arrangement adjustment region and the arrangement region of the first component is less than the distance limiting parameter. Therefore, the candidate arrangement adjustment regions translated rightward based on the candidate adjustment step of 4 microns may be used as the arrangement regions of the second component.

In some embodiments, when all the candidate adjustment steps in the adjustment step set have been traversed, and still no proper candidate adjustment step can be found for the arrangement of the second component according to one of the following solutions when the intersection does not exist between the candidate arrangement adjustment regions and the genus region, and the distance between the candidate arrangement adjustment region and the arrangement region of the first component is greater than or equal to the distance limiting parameter.

(1) The layout of the second component is not adjusted.

The second component is directly arranged according to an original arrangement region of the second component.

(2) All candidate arrangement adjustment regions are translated in a first translation direction according to the i^{th} candidate adjustment step in the adjustment step set. A part of the candidate arrangement adjustment regions is translated in a second translation direction according to the j^{th} candidate adjustment step. For example, while all the candidate arrangement adjustment regions in FIG. 9 are adjusted horizontally leftward by 4 microns, the candidate arrangement adjustment regions in columns of odd integers are adjusted vertically upward by 2 microns.

When the intersection does not exist between the translated candidate arrangement adjustment regions and the genus region, and the distance between the translated candidate arrangement adjustment region and the arrangement region of the first component is greater than or equal to the distance limiting parameter, the second component may be arranged in the translated candidate arrangement adjustment region.

When the intersection exists between the translated candidate arrangement adjustment regions and the genus region, or the distance between the translated candidate arrangement adjustment region and the arrangement region of the first component is less than the distance limiting parameter, the candidate arrangement adjustment regions are re-translated based on the i^{th} candidate adjustment step and the (j+1)^{th} candidate adjustment step in the adjustment step set, until the second component can be arranged in the translated candidate arrangement adjustment region, or all combinations of the i^{th} candidate adjustment step and the j^{th} candidate adjustment step in the adjustment step set have been traversed.

In this embodiment, the candidate arrangement adjustment regions are translated based on the candidate adjustment step in the adjustment step set, so that whether a proper arrangement region exists on the chip layout can be determined. In this way, the density of the second component can be increased, and a limitation requirement of the distance between the first components and the second components can be satisfied.

In a possible scenario, after the second component is arranged on the chip layout, to better implement a function of the second component, the computer device may properly add the second component in the genus region without affecting normal operation of the first component, if at least one of the following situation exists: an area of the genus region corresponding to the first component is excessively large, or the density of the second component in some regions is relatively small.

In some embodiments, when the area of the genus region is greater than an area threshold, the second component is added to the genus region. A quantity of the added second components is positively correlated with the area of the genus region.

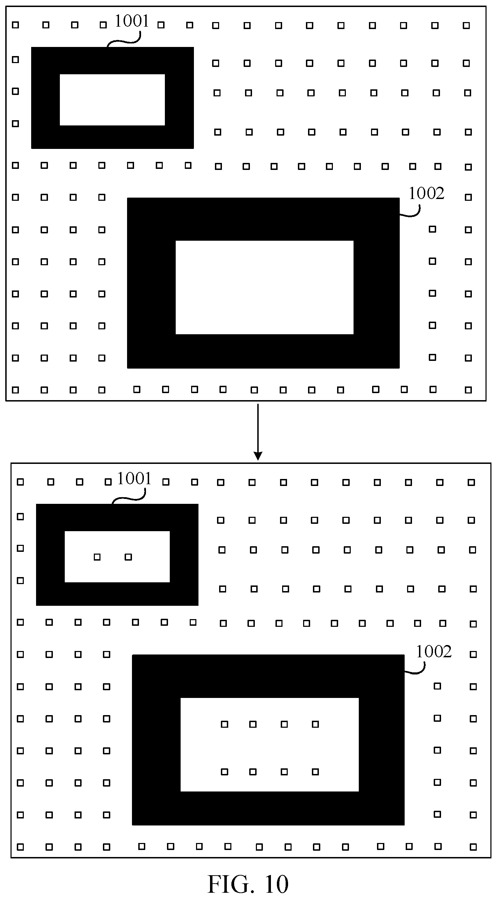

FIG. 10 is a schematic diagram in which a second component is added to a genus region when an area of the genus region is greater than an area threshold according to an exemplary embodiment of this application.

As shown in FIG. 10, the second components are evenly arranged in regions other than the arrangement regions of the first components and the genus regions on the chip layout. When areas of the genus regions corresponding to the first component 1001 and the first component 1002 are both greater than the area threshold, a second component may be added to the genus regions corresponding to the first component 1001 and the first component 1002. A quantity of the added second components in the genus region corresponding to the first component 1001 is 2, and a quantity of the added second components in the genus region corresponding to the first component 1002 is 8. The quantity of the added second components is positively correlated with the area of the genus region.

When the second component is added to the genus region, it is also necessary to consider that the distance between the added second component and the existing first component needs to be greater than or equal to the distance limiting parameter. Therefore, to add the second component to the genus region, a candidate addition region of the second component may be determined. When a distance between the candidate addition region and the arrangement region of the first component is greater than or equal to the distance limiting parameter, the second component is added to the candidate addition region.

The candidate addition region may be a region determined from the genus region based on the second arrangement parameter (for example, the size parameter of the second component).

In some embodiments, a plurality of subblocks may be determined from the chip layout in various manners. For example, the chip layout may be divided into a plurality of rectangular subblocks according to a preset side length; or the chip layout is irregularly segmented, to form the plurality of subblocks; or after one subblock is determined, the subblock is slided, to obtain other subblocks on the chip layout, where different subblocks may intersect or not intersect. When density of the second component in the subblock is less than a density threshold, the genus regions in the subblocks may be arranged in descending order of areas, to obtain a genus region sequence. When the density of the second component in the subblock is less than the density threshold, the second components are sequentially arranged in the genus region in the genus region sequence, until the density of the second component is greater than or equal to the density threshold.

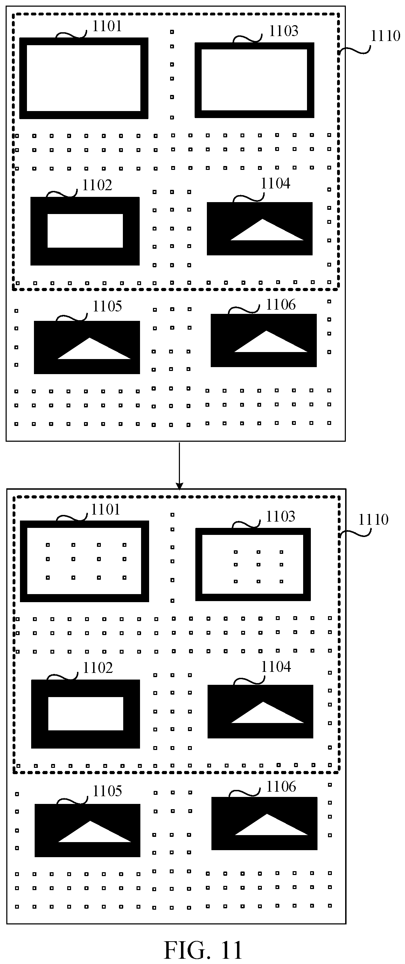

FIG. 11 is a schematic diagram in which a second component is added to a genus region when density of the second component in a subblock is less than a density threshold according to an exemplary embodiment of this application.

As shown in FIG. 11, a first component 1101, a first component 1102, a first component 1103, a first component 1104, a first component 1105, and a first component 1106 are arranged on the chip layout.

In the chip layout, a subblock 1110 exists, and the first component 1101, the first component 1102, the first component 1103, and the first component 1104 are all located in the subblock 1110.

In some embodiments, arrangement density of second components in the subblock 1110 may be calculated.

In some embodiments, a ratio of an arrangement area of the second components in the subblock 1110 to an area of the subblock may be used as the arrangement density of the second component.

Assuming that the arrangement density of the second component in the subblock 1110 is 4.5%, and the density threshold is 5%, the genus regions in the subblock 1110 may be arranged in descending order of areas, to obtain a genus region sequence: a genus region A, a genus region B, a genus region C, and a genus region D. The genus region A is located in the first component 1101, the genus region B is located in the first component 1102, the genus region C is located in the first component 1103, and the genus region D is located in the first component 1104.

In some embodiments, the second components may be sequentially arranged in the genus regions in the genus region sequence until the density of the second component is greater than or equal to the density threshold. For example, in the genus region A corresponding to the first component 1101, the second components are first added based on second arrangement parameters (such as a size parameter of the second component, a distance limiting parameter between the second component and the first component, and a spacing between the second components).

The arrangement density (assumed to be 4.8%) of the second components in the subblock 1110 after the second components are added to the genus region A corresponding to the first component 1101 is calculated. Because the arrangement density is still less than the density threshold, the second components may be subsequently added to the second genus region (that is, the genus region C corresponding to the first component 1103) in the genus region sequence.

Similarly, the second component may be added in the genus region C corresponding to the first component 1103 based on the second arrangement parameter (such as the size parameter of the second component, the distance limiting parameter between the second component and the first component, and the spacing between the second components).

The arrangement density (assumed to be 5.1%) of the second components in the subblock 1110 after the second components are added to the genus region C corresponding to the first component 1103 is calculated. Because the density threshold has been reached, the addition of the second components can be stopped.

For each of the plurality of subblocks determined from the chip layout, the second component may be added in the foregoing manner, so that for each subblock, the arrangement density of the second component in the subblock is greater than or equal to the density threshold. In this embodiment, the genus regions in the subblock are arranged in descending order of area s, to obtain the genus region sequence, and the second components are sequentially arranged in the genus regions in the genus region sequence until the density of the second component is greater than or equal to the density threshold. In this way, the density of the second component in the subblock on the chip layout can be improved, an impact caused by arranging the second components in the genus region to the first components is reduced, and a requirement of the distance between the first components and the second components is satisfied. Therefore, the quality of component arrangement on the chip layout can be improved.

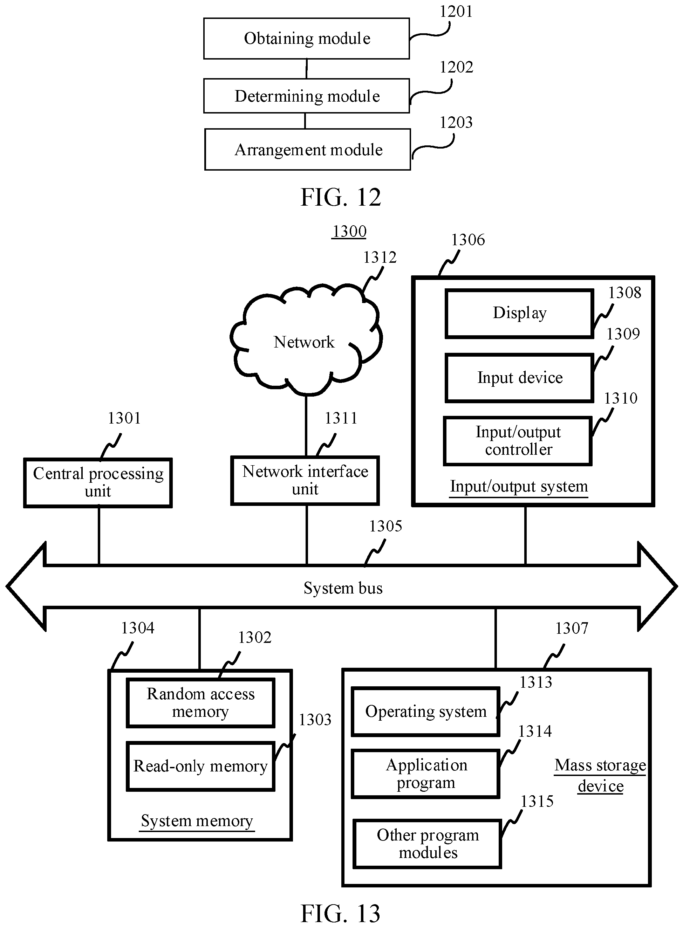

FIG. 12 is a structural block diagram of an apparatus for component arrangement on a chip layout according to an exemplary embodiment of this application. The apparatus includes:
an obtaining module 1201, configured to obtain a chip layout including a first region for arranging a first chipset component and a second region for arranging a second chipset component;
a determining module 1202, configured to determine, based on a first arrangement parameter of the first component, a genus region for the first component on the chip layout, the first arrangement parameter being used for arrangement of the first component on the chip layout, and the genus region being a hollow region located in the first region of the chip layout; and
an arrangement module 1203, configured to arrange the second component in the second region of the chip layout based on a second arrangement parameter of the second component and the genus region when the genus region does not support arrangement of the second component, the second region being different from the first region.

In some embodiments, the first arrangement parameter includes an arrangement node sequence, the arrangement node sequence includes sequentially connected arrangement nodes, and a communication region formed by sequentially connecting the arrangement nodes is an arrangement region of the first component. The determining module 1202 is configured to:
determine a first communication node and a second communication node in the arrangement node sequence, the first communication node and the second communication node being adjacent nodes in the arrangement node sequence, and a connection line between the first communication node and the second communication node being located in the communication region;
sequentially traverse the arrangement nodes in the arrangement node sequence in a first direction by using the first communication node as a start, to obtain a first closed curve formed by connecting the arrangement nodes;
sequentially traverse the arrangement nodes in the arrangement node sequence in a second direction by using the second communication node as a start, to obtain a second closed curve formed by connecting the arrangement nodes, the first direction being opposite to the second direction; and
determine the genus region based on the first closed curve and the second closed curve.

In some embodiments, the determining module 1202 is configured to:
determine an arrangement node having same node coordinates with a head arrangement node in the arrangement node sequence as the first communication node; and
determine an adjacent node of the first communication node as the second communication node.

In some embodiments, the determining module 1202 is configured to:
determine an enclosed region formed by the second closed curve as the genus region when the enclosed region formed by the second closed curve is located within an enclosed region formed by the first closed curve.

In some embodiments, the arrangement module 1203 is configured to:
determine candidate arrangement regions for the second component on the chip layout based on the second arrangement parameter; and
arrange, when the genus region does not support the arrangement of the second component, and an intersection exists between the candidate arrangement regions and the genus region, the second component in a region other than the intersection in the candidate arrangement regions, the region being a region other than the first region on the chip layout.

In some embodiments, the arrangement module 1203 is configured to:
arrange the second component in the candidate arrangement region serving as the second region when the genus region supports the arrangement of the second component and the intersection exists between the candidate arrangement regions and the genus region, or when the intersection does not exist between the candidate arrangement regions and the genus region.

In some embodiments, the arrangement module 1203 is configured to:
determine an arrangement support situation of the genus region for the second component based on component information of the first component, the component information including at least one of a component type, a component structure, or a component function; or
determine an arrangement support situation of the genus region for the second component based on an on/off state of a target control, the target control having a genus arrangement control function.

In some embodiments, the arrangement module 1203 is configured to:
match the first arrangement parameter of the first component with a reference arrangement parameter of a reference component; and
use a component structure of the reference component as the component structure of the first component when the matching succeeds, the reference component being a component having the component structure stored therein.

In some embodiments, the second arrangement parameter includes a distance limiting parameter between the second component and the first component. The arrangement module 1203 is configured to:
determine candidate arrangement adjustment regions for the second component, the candidate arrangement adjustment regions being candidate arrangement regions for layout adjustment of the second component, density of the second component after the layout adjustment being higher than density of the second component before the layout adjustment; and
arrange the second component in the candidate arrangement adjustment region when the intersection does not exist between the candidate arrangement adjustment regions and the genus region, and a distance between the candidate arrangement adjustment region and the arrangement region of the first component is greater than or equal to the distance limiting parameter.

In some embodiments, the arrangement module 1203 is configured to:
determine an adjustment step set when an intersection exists between the candidate arrangement adjustment regions and the genus region, or the distance between the candidate arrangement adjustment region and the arrangement region of the first component is less than the distance limiting parameter, the adjustment step set including at least one candidate adjustment step;
translate the candidate arrangement adjustment regions based on the i^{th} candidate adjustment step in the adjustment step set;
arrange the second component in the translated candidate arrangement adjustment region when the intersection does not exist between the translated candidate arrangement adjustment regions and the genus region and a distance between the translated candidate arrangement adjustment region and the arrangement region of the first component is greater than or equal to the distance limiting parameter; and
translate the candidate arrangement adjustment regions based on the (i+1)^{th} candidate adjustment step in the adjustment step set when an intersection exists between the translated candidate arrangement adjustment regions and the genus region, or the distance between the translated candidate arrangement adjustment region and the arrangement region of the first component is less than the distance limiting parameter.

In some embodiments, the arrangement module 1203 is configured for at least one of the following:
adding the second component in the genus region when an area of the genus region is greater than an area threshold, a quantity of the added second components being positively correlated with the area of the genus region; or
determining a subblock on the chip layout, the subblock including at least one genus region; and adding the second component in the at least one genus region when the density of the second component in the subblock is less than the density threshold.

In some embodiments, the arrangement module 1203 is configured to:
determine a candidate addition region for the second component; and
add the second component in the candidate addition region when a distance between the candidate addition region and the arrangement region of the first component is greater than or equal to the distance limiting parameter.

In some embodiments, the arrangement module 1203 is configured to:
sort the at least one genus region in the subblock in descending order of areas, to obtain a genus region sequence; and
sequentially arrange the second component in the at least one genus region in the genus region sequence when the density of the second component in the subblock is less than the density threshold, until the density of the second component is greater than or equal to the density threshold.

FIG. 13 is a schematic structural diagram of a computer device according to an exemplary embodiment of this application. Specifically, a computer device 1300 includes a central processing unit (CPU) 1301, a system memory 1304 including a random access memory 1302 and a read-only memory 1303, and a system bus 1305 connecting the system memory 1304 to the CPU 1301. The computer device 1300 further includes a basic input/output system (I/O system) 1306 that facilitates transfer of information between various devices in the computer, and a mass storage device 1307 configured to store an operating system 1313, an application program 1314, and other program modules 1315.

The basic I/O system 1306 includes a display 1308 configured to display information and an input device 1309 such as a mouse or keyboard for a user to input information. Both the display 1308 and the input device 1309 are connected to the CPU 1301 via an input/output controller 1310 connected to the system bus 1305. The basic I/O system 1306 may alternatively include the input/output controller 1310 for receiving and processing inputs from a plurality of other devices such as a keyboard, a mouse, or an electronic stylus. Similarly, the input/output controller 1310 also provides an output to a display screen, a printer, or other types of output devices.

The mass storage device 1307 is connected to the CPU 1301 through a mass storage controller (not shown) connected to the system bus 1305. The mass storage device 1307 and a related computer-readable medium thereof provide non-volatile storage for the computer device 1300. In other words, the mass storage device 1307 may include a computer-readable medium (not shown) such as a hard disk or a drive.

Without loss of generality, the computer-readable medium may include a computer storage medium and a communication medium. The computer storage medium includes volatile and non-volatile media, and removable and non-removable media implemented by using any method or technology configured to store information such as a computer-readable instruction, a data structure, a program module, or other data. Computer storage media include a random access memory (RAM), a read-only memory (ROM), a flash, or other solid-state storage technologies, a compact disc read-only memory (CD-ROM), a digital versatile disc (DVD), or other optical storage, tape cartridges, magnetic tapes, disk storage, or other magnetic storage devices. Certainly, a person skilled in the art may know that the computer storage medium is not limited to the foregoing types. The system memory 1304 and the mass storage device 1307 may be collectively referred to as a memory.

The memory has one or more programs stored therein. The one or more programs are configured to be executed by one or more CPUs 1301. The one or more programs include computer instructions for implementing the foregoing method. The CPU 1301 executes the one or more programs to implement the method for component arrangement on a chip layout provided in the foregoing method embodiments.

According to the embodiments of this application, the computer device 1300 may alternatively be connected to a remote computer by a network such as the Internet for operation. In other words, the computer device 1300 may be connected to a network 1312 through a network interface unit 1311 connected to the system bus 1305, or may use the network interface unit 1311 to be connected to other types of networks or remote computer systems (not shown).

The memory further includes one or more programs. The one or more programs are stored in the memory. The one or more programs includes steps performed by the computer device for performing the method provided by the embodiments of this application.

An embodiment of this application further provides a computer-readable storage medium. At least one computer instruction is stored in the readable storage medium, and the at least one computer instruction is loaded and executed by a processor to implement the method for component arrangement on a chip layout described in any of the above embodiments.

In some embodiments, the computer-readable storage medium may include: a ROM, a RAM, a solid-state drive (SSD), an optical disc, or the like. The RAM may include a resistance random access memory (ReRAM) and a dynamic random access memory (DRAM).

An embodiment of this application provides a computer program product. The computer program product includes computer instructions. The computer instructions are stored in a computer-readable storage medium. A processor of a computer device reads the computer instructions from the computer-readable storage medium, and the processor executes the computer instructions, to enable the computer device to perform the method for component arrangement on a chip layout described in the above embodiments.

A person of ordinary skill in the art may understand that all or a part of the operations of the embodiments may be implemented by hardware or a program instructing relevant hardware. The program may be stored in a computer-readable storage medium. The storage medium may be a read-only memory, a magnetic disk, an optical disc, or the like.

The foregoing descriptions are merely exemplary embodiments of this application, but are not intended to limit this application. Any modification, equivalent replacement, or improvement made within the spirit and principle of this application shall fall within the protection scope of this application.

## Claims

1. A method for component arrangement on a chip layout, executable by a computer device, the method comprising:
obtaining a chip layout comprising a first region for arranging a first chipset component and a second region for arranging a second chipset component;
determining, based on a first arrangement parameter of the first chipset component, a genus region for the first chipset component on the chip layout, the genus region being a hollow region located in the first region of the chip layout; and
when the genus region does not support arrangement of the second chipset component, arranging the second chipset component in the second region of the chip layout based on a second arrangement parameter of the second chipset component and the genus region, the second region being different from the first region.

2. The method according to claim 1, wherein the first arrangement parameter comprises an arrangement node sequence, the arrangement node sequence comprises sequentially connected arrangement nodes, and a communication region formed by sequentially connecting the arrangement nodes is an arrangement region of the first chipset component; and
determining, based on the first arrangement parameter of the first chipset component, the genus region for the first chipset component on the chip layout comprises:
determining a first communication node and a second communication node in the arrangement node sequence, wherein the first communication node and the second communication node are adjacent nodes in the arrangement node sequence, and a connection line between the first communication node and the second communication node is located in the communication region;
sequentially traversing the arrangement nodes in the arrangement node sequence in a first direction by using the first communication node as a start, to obtain a first closed curve formed by connecting the arrangement nodes;
sequentially traversing the arrangement nodes in the arrangement node sequence in a second direction by using the second communication node as a start, to obtain a second closed curve formed by connecting the arrangement nodes, the first direction being opposite to the second direction; and
determining the genus region based on the first closed curve and the second closed curve.

3. The method according to claim 2, wherein determining the first communication node and the second communication node in the arrangement node sequence comprises:
determining an arrangement node having same node coordinates with a head arrangement node in the arrangement node sequence as the first communication node; and
determining an adjacent node of the first communication node as the second communication node.

4. The method according to claim 2 or 3, wherein determining the genus region based on the first closed curve and the second closed curve comprises:
determining an enclosed region formed by the second closed curve as the genus region when the enclosed region formed by the second closed curve is located within an enclosed region formed by the first closed curve.

5. The method according to any one of claims 1 to 4, wherein arranging the second chipset component in the second region of the chip layout based on the second arrangement parameter of the second chipset component and the genus region comprises:
determining candidate arrangement regions for the second chipset component on the chip layout based on the second arrangement parameter; and
arranging, when the genus region does not support the arrangement of the second chipset component and an intersection exists between the candidate arrangement regions and the genus region, the second chipset component in a region other than the intersection in the candidate arrangement regions, the region being a region other than the first region on the chip layout .

6. The method according to claim 5, further comprising:
arranging the second chipset component in the candidate arrangement regions serving as the second region, when the genus region supports the arrangement of the second chipset component and the intersection exists between the candidate arrangement regions and the genus region, or when the intersection does not exist between the candidate arrangement regions and the genus region.

7. The method according to claim 5 or 6, further comprising: after determining the candidate arrangement regions for the second chipset component on the chip layout based on the second arrangement parameter,
determining an arrangement support situation of the genus region for the second chipset component based on component information of the first chipset component, wherein the component information comprises at least one of a component type, a component structure, or a component function; or
determining an arrangement support situation of the genus region for the second chipset component based on an on/off state of a target control, the target control having a genus arrangement control function.

8. The method according to claim 7, wherein determining the arrangement support situation of the genus region for the second chipset component based on the component information of the first chipset component comprises:
matching the first arrangement parameter of the first chipset component with a reference arrangement parameter of a reference chipset component; and
using a component structure of the reference chipset component as the component structure of the first chipset component when the matching succeeds, wherein the reference chipset component is a chipset component storing the component structure.

9. The method according to any one of claims 1 to 8, wherein the second arrangement parameter comprises a distance limiting parameter between the second chipset component and the first chipset component; and
the method further comprises: after arranging the second chipset component in the second region of the chip layout based on the second arrangement parameter of the second chipset component and the genus region,
determining candidate arrangement adjustment regions for the second chipset component, the candidate arrangement adjustment regions being candidate arrangement regions for layout adjustment of the second chipset component, density of the second chipset component after the layout adjustment being higher than density of the second chipset component before the layout adjustment; and
arranging the second chipset component in the candidate arrangement adjustment region when an intersection does not exist between the candidate arrangement adjustment regions and the genus region and a distance between the candidate arrangement adjustment region and the arrangement region of the first chipset component is greater than or equal to the distance limiting parameter.

10. The method according to claim 9, further comprising:
determining an adjustment step set when the intersection exists between the candidate arrangement adjustment regions and the genus region, or the distance between the candidate arrangement adjustment region and the arrangement region of the first chipset component is less than the distance limiting parameter, the adjustment step set comprising at least one candidate adjustment step;
translating the candidate arrangement adjustment regions based on an i^{th} candidate adjustment step in the adjustment step set;
arranging the second chipset component in the translated candidate arrangement adjustment region when an intersection does not exist between the translated candidate arrangement adjustment regions and the genus region and a distance between the translated candidate arrangement adjustment region and the arrangement region of the first chipset component is greater than or equal to the distance limiting parameter; and
translating the candidate arrangement adjustment regions based on an (i+1)^{th} candidate adjustment step in the adjustment step set when the intersection exists between the translated candidate arrangement adjustment regions and the genus region, or the distance between the translated candidate arrangement adjustment region and the arrangement region of the first chipset component is less than the distance limiting parameter.

11. The method according to claim 1 to 10, wherein after arranging the second chipset component in the second region of the chip layout based on the second arrangement parameter of the second chipset component and the genus region, the method further comprises at least one of:
adding the second chipset component in the genus region when an area of the genus region is greater than an area threshold, a quantity of added second chipset components being positively correlated with the area of the genus region; or
determining a subblock on the chip layout, the subblock comprising at least one genus region; and adding the second chipset component in the at least one genus region when density of the second chipset component in the subblock is less than a density threshold.

12. The method according to claim **11,** wherein the second arrangement parameter comprises a distance limiting parameter between the second chipset component and the first chipset component, and adding the second chipset component in the genus region comprises:
determining a candidate addition region for the second chipset component; and
adding the second chipset component in the candidate addition region when a distance between the candidate addition region and the arrangement region of the first chipset component is greater than or equal to the distance limiting parameter.

13. The method according to claim 11, wherein adding the second chipset component in the genus region when the density of the second chipset component in the subblock is less than the density threshold comprises:
sorting the at least one genus region in the subblock in descending order of areas, to obtain a genus region sequence; and
sequentially arranging the second chipset component in the at least one genus region in the genus region sequence when the density of the second chipset component in the subblock is less than the density threshold, until the density of the second chipset component is greater than or equal to the density threshold.

14. An apparatus for component arrangement on a chip layout, the apparatus comprising:
an obtaining module, configured to obtain a chip layout comprising a first region for arranging a first chipset component and a second region for arranging second chipset component;
a determining module, configured to determine, based on a first arrangement parameter of the first chipset component, a genus region for the first chipset component on the chip layout, the genus region being a hollow region located in the first region of the chip layout; and
an arrangement module, configured to arrange the second chipset component in the second region of the chip layout based on a second arrangement parameter of the second chipset component and the genus region when the genus region does not support arrangement of the second chipset component, the second region being different from the first region.

15. A computer device, comprising a processor and a memory, the memory storing at least one computer instruction that, when executed by the processor, to implement the method for component arrangement on the chip layout according to any one of claims 1 to 13.

16. A computer-readable storage medium, storing at least one computer instruction that, when loaded and executed by a processor, to implement the method for component arrangement on the chip layout according to any one of claims 1 to 13.

17. A computer program product, comprising computer instructions stored in a computer-readable storage medium; and a processor of a terminal reading the computer instructions from the computer-readable storage medium, and the processor executing the computer instructions, to enable the terminal to perform the method for component arrangement on the chip layout according to any one of claims 1 to 13.
